# EUROPEAN PATENT APPLICATION

(11) **EP 0 657 309 A1**
(43) Date of publication of application: **14.06.1995**
(21) Application number: 94308566.2
(22) Date of filing: 21.11.1994
(51) Int. Cl.: B44C 1/175, C04B 41/45, H05K 3/10, H05K 3/20

(54) **Method of producing transfer sheets**

(30) Priority: 02.12.1993 GB 9324740
(71) Applicant: COOKSON MATTHEY PRINT LIMITED, London EC2V 6EQ (GB)
(72) Inventor: Lawton, Keith, Stoke-On-Trent, Staffordshire, ST7 2AZ (GB)
(74) Representative: Brewer, Leonard Stuart

(57) **Abstract**

A decorative or functional transfer carrying a pattern, particularly for decorating ceramics, is produced by printing the pattern in adhesive or a precursor thereof on transfer paper by an electronically controlled printing process so that the pattern corresponds to an electronically stored or generated digital image, in the case of a precursor converting it to the adhesive, and applying to the adhesive or precursor thereof decorative or functional material in finely divided form, such that the material is stuck by the adhesive and hence forms the pattern in the material.

## Description

This invention concerns a method of producing a decorative transfer or functional transfer and its use for forming a decorative or functional pattern on an article.

There is a considerable production of transfers, sometimes called "decals" or "decalcomania", which are used particularly for the decoration of substrates such as ceramic tableware, glass or glass ceramics, ceramic sanitary ware, tiles, vitreous enamels such as enamelled iron, aluminium or steel, and other ceramic ware including "giftware" (vases, gift items *etc*). Such transfers are generally produced by screen printing inks containing ceramic colours onto a transfer paper which may be a traditional water-slide paper or a wax-coated paper for heat release transfers. The transfer is employed to transfer its pattern to a substrate article which is then fired in a kiln to produce the desired decorated article. The transfers are sometimes used without firing to decorate articles which are not able to resist firing at several hundred degrees C, such as plastics or wax candles. There is some production of transfers by lithography, although this is relatively small scale and is particularly time-consuming.

The use of an ink-jet printer to print an adhesive ink onto a substrate for electronic circuits, applying a low-melting metal powder and heating the pattern to form conductive traces for circuit manufacture, has been proposed in EP 414,363.

There remains a need for improved transfer production technology, especially for patterns to be reproduced onto a transfer paper from a computer memory carrying a scanned image, a computer graphics created image or a computer modified image.

The present invention provides a method of producing a decorative or functional transfer bearing a pattern, which method comprises printing the pattern in adhesive or a precursor thereof on transfer paper by an electronically controlled printing process so that the pattern corresponds to an electronically stored or generated digital image, in the case of a precursor converting it to the adhesive, and applying to the adhesive or precursor thereof decorative colouring, or functional, material in finely divided form, such that the material is stuck by the adhesive and hence forms the pattern in the material.

The invention also provides a transfer carrying a pattern of decorative or functional material stuck to transfer paper by adhesive, the adhesive or a precursor thereof having been printed in that pattern on the transfer paper by an electronically controlled printing process so that the pattern corresponds to an electronically stored or generated digital image.

The invention provides also a method of forming a decorative or functional pattern on an article, which method comprises transferring the pattern to the article from the present transfer.

The invention offers various advantages. In particular, it enables transfers to be produced without the time-consuming and technical difficulties of screen printing or lithography. Extremely advantageous is that transfers are produced by an electronically controlled printing process, so that the pattern corresponds to an electronically stored or generated digital image. The image can be generated on computer, or an image already stored on the computer can be employed. The invention enables patterns to be generated on computer, either from scratch or by modifying a computer-stored image, and then used directly to print transfers bearing the pattern or electronically stored for subsequent such printing. Alternatively, a pattern can be scanned into the computer and then used in the same way. The present method also enables a series of different patterns to be printed readily, for instance from a computer-stored library of patterns. Patterns can also readily be modified by the computer, so that for instance a series of patterns can be produced, each pattern differing slightly from one another, for instance in text (for example a reference number) or picture. Since the pattern is defined in adhesive, which can be formed by passing adhesive composition or adhesive precursor composition through one or more nozzles onto the transfer paper, this is advantageous over the alternative of passing a composition of decorative or functional material through one or more nozzles and thus defining the pattern in the material directly, because such materials, being often metals or metal oxides, tend to block and abrade the nozzles.

The term "decorative" as used herein is intended to cover patterns which simply carry text as well as more artistic patterns. The transfer can alternatively be functional, for example a microwave browning transfer. The decorative material can be a texture material, coloured or colour-less, which produces a textured effect on the transfer and on the article on which the transfer is used. Preferably, the decorative or functional material is a decorative colouring material.

In the present invention, a decorative colouring material means any material, and in any colour or shade, usable to provide a decorative coloured pattern on a transfer. In particular, there are included ceramic colours as described in more detail hereafter, precious metal powders or flakes, such as gold or gold alloy powders or flakes, and iridescent or micaceous-type pigments. Alternatively, a functional material can be employed, *ie* a material usable to provide a functional pattern on a transfer. It will be appreciated that the decorative or functional material applied may be developed after application to that desired finally on the transfer.

Known printing processes can be employed. The printing preferably utilizes a liquid "ink" comprising adhesive components. The printing particularly utilizes droplets of such liquid ink from nozzles being projected onto the paper to form the print. Ink-jet printing is particularly preferred. Included by the term ink-jet printing is "bubble-jet" (trade mark of Canon) printing. Included by the term also is phase change printing, otherwise called solid ink-jet printing, in which solid ink stock is melted and fed to nozzles so that liquid ink droplets from nozzles are projected onto the paper to form the print. The ink-jet printer can be of the drop-on-demand type, which can have array heads. The ink-jet printer can alternatively be of the continuous type, which can have raster or array heads. The invention also envisages the application of laser jet printing using the electrostatic attraction of adhesive particles onto a transfer paper, and bonding the adhesive onto the paper by heating. Other computer-controlled printing processes may be developed for use in the present invention.

In the present method, one preferably prints the pattern in adhesive. Alternatively, however, one prints the pattern in adhesive precursor and converts the precursor to adhesive. Either way, the pattern is formed in adhesive, and its sticking of the decorative or functional material forms the pattern in the material. Thus, one can print the desired pattern in an adhesive precursor which is subsequently activated, *eg* by heat or radiation, for instance ultra-violet or infra-red radiation, to form the adhesive itself. For example, one can print the pattern in a radiation-curable adhesive composition, apply the decorative or functional material, and then cure the adhesive composition by exposure to radiation; it can be seen that in this embodiment the adhesive is formed after the decorative or functional material has been applied, and that the adhesive is formed and at the same time sticks the material. One can print the pattern in an adhesive precursor which is one component of a two-component adhesive. The second component can be applied before or after the printed first component. In one embodiment, the transfer paper is coated with a continuous film of second component, either before or after printing the first component in the pattern; it can be seen that adhesive will be formed only in the printed area. If the second component in this embodiment is volatile, it can conveniently volatilise off the non-printed area. In another embodiment, the first component is printed in the pattern and the second component is applied in admixture with the decorative or functional material; again, adhesive is formed only where the first component is printed, and the decorative or functional material is hence stuck in this pattern. It can be seen that in this embodiment the adhesive is formed at the same time as the decorative or colourant material is applied. Preferably, however, the pattern is printed in adhesive and the decorative or functional material in finely divided form is applied thereto.

The actual adhesive chosen may vary according to the printing process used, whether or not an adhesive precursor is employed, and whether a water-slide or heat-activatable transfer is to be produced. The adhesive may be, for example, a solvent-based, water-based, or emulsion or dispersion adhesive. Preferably the adhesive or precursor thereof is formulated to have the appropriate viscosity to perform as an ink for ink-jet printing. The actual type of printing chosen affects to some extent the viscosity of the ink, although the ink usually has a viscosity of 1-30, preferably 15-25, mPas, though values as low as 1-3mPas can be used. The ink in the transfer produced should desirably contain only components that are driven off or burned off cleanly during normal firing in a kiln, although the ink may contain substances intended to improve adhesion of the decorative or functional material to a ceramic or other substrate upon firing, or other components to improve the performance or appearance of the transfer. Desirably, the ink chosen dries quickly. Preferably the adhesive is present as a layer of thickness of approximately a few microns, for example 1-30, for instance 1-10, microns, for example 1-2 microns; the layer is usually tacky. In the present method, the adhesive is usually tacky. In a particular embodiment, a tacky layer of the adhesive of from 1-30, for instance 1-10, for example 1-2, microns, is printed. The adhesive may be tacky as printed - for instance in the case of sucrose acetate isobutyrate a sufficiently thin film can be formed which is inherently tacky; the surface tack can then be removed on application of the decorative or functional material. Usually, however, the printed adhesive loses solvent or water to render it sufficiently tacky to stick the decorative or functional material.

In a particular embodiment, adhesive precursor layer is rendered sufficiently tacky to retain colour powder by heating, and in such instance, the adhesive precursor layer may be a film or a fused powder deposit printed onto the transfer paper.

After printing the adhesive or precursor thereof, and converting the precursor to the adhesive if this is desired at this stage, the functional or decorative colouring material is applied. This can be done for instance in ways known for dusting colours in the production of lithographic or screen printed transfers. Desirably, the functional or decorative colouring material is loaded onto the adhesive patterns when the adhesive is sufficiently tacky, for example by application from a pad carrying the material, scattered from a vibrating hopper or similar methods. The material is then desirably caused to adhere to the adhesive by applying light pressure to the surface, for example using a plush pad or felt pad. Excess powder can then be cleaned off, for example using further mechanical action using a plush or felt pad, cotton wool or similar material, optionally with the aid of vacuum. Desirably, the non-pattern areas of the transfer paper are cleaned, for example by rubbing using a soft absorbent material such as wood flour. The process may then be repeated for different colours and patterns to be combined with the original. In an alternative technique for applying the decorative or functional material, the printed adhesive or precursor thereof is charged with a corona discharge and the material thereby attracted to it.

The decorative colouring material is preferably one or more of ceramic colours, precious metal powders and/or flakes and iridescent or micaceous type pigments.

Ceramic colours are very well known in the transfer art, and generally do not need further description. Known ceramic colours can be employed. The powders generally comprise an inorganic oxide pigment mixed with a glass or vitreous frit, known as a flux, though in some instances the pigment is used without a flux. The present material, preferably a ceramic colour, usually has substantially all its particles of maximum dimension below 350µm. In the case of texture materials, substantially all the particles conveniently sieve between 125 and 350 microns. Preferably, however, the present material has substantially all its particles of maximum dimension below 150µm. The material, usually a powder, should suitably be of a particle size below 100µm, usually below about 50µm, and may advantageously have a size such that 50% of the particles is below about 15µm, for example 50% of the particles below a value from 4 to 12µm. In a preferred embodiment, the particle size is 5-25 microns. Sizes in this specification are as measured by laser diffraction unless otherwise indicated; a Malvern machine may be used for this. The ratio of colour pigment to any flux in the present ceramic colours may vary according to the end use of the transfer (and to some extent on the pigment itself, for example cobalt colours may suffer from bleeding and therefore tend to be used in rather higher proportions to flux than most other colours) and may suitably be from 0.1 to 9, *eg* 0.2 to 5, parts of flux to 1 part of pigment, usually from about 2 to about 5 parts of flux to 1 part of colour for on-glaze transfers, and about 0.1 to about 0.4, *eg* about 0.2 to about 0.4, parts of flux to 1 part of colour for under-glaze transfers, by weight.

After application of decorative or functional material, pattern can again be formed in adhesive and different such material applied, preferably by repeating the steps of the present method, to build up a multi-colour or complex effect transfer. This is particularly useful in producing a multi-colour decorative transfer.

After application of decorative or functional material, a coating of flux may be applied, for instance to lighten the effect of a decorative colouring material.

The transfer bearing the adhered material is desirably protected by a covercoat. Known covercoats can be employed. These usually are a resin varnish, such as a solution of an acrylic resin or a cellulose derivative, which dries to give support to and maintain integrity of the pattern material whilst it is being handled and being transferred to the ceramic or other substrate. The covercoat can be applied in known way. It can be applied by spraying, K-bar coating or screen printing.

It can be seen that the present transfer carries a pattern of decorative or functional material stuck to transfer paper by adhesive in that pattern. In a particular embodiment, the transfer comprises a transfer paper carrying at least one printed decorative pattern comprising a layer, generally a tacky layer, of adhesive, said adhesive carrying or incorporating a decorative colouring material in powder or flake form.

As mentioned above, the transfer paper may be a conventional water-slide transfer paper, or may be a heat-activatable transfer paper, such as a wax-coated paper for heat release transfers. For some applications, a silicone or similar release paper may be used. The term transfer paper is intended to include non-paper substrates such as a film or non-woven materials performing the same function.

The present transfer can be employed in known way. In use, the pattern layer of the transfer is separated from the transfer paper and is applied by the appropriate means to a ceramic, glass, vitreous or other substrate, and is generally fired to drive off any organic components of the transfer and to fuse the pattern, *eg* of ceramic colour, onto the substrate. Firing temperatures and times depend upon the particular substrate and can be established in generally known manner. The present transfers may be used for on-glaze, under-glaze or in-glaze decoration.

The present transfers are preferably used on ceramics or glass.

Glass transfers are generally fired to a maximum temperature of between 560 and 600°C and the cycle time can vary generally between 10 and 90 minutes. Cycle times can be, however, up to 3 hours or longer. Typically, a continuous firing, as opposed to an intermittent firing, may be around 20-30 minutes.

Ceramic transfers fired on-glaze, *eg* on to pottery, may be fired for example to a maximum temperature of between 750 and 900°C. A typical firing is for a number of hours *eg* overnight, to 800°C, approached at 100-200° per hour, with a 1-hour soak at maximum temperature. A typical fast-fire cycle is to 900°C with a soak of 10 minutes and a cycle time of 45-90 minutes.

Underglaze firings are usually hardened-on or "once-fired". In the former case, the firing cycle can be similar to an overnight on-glaze cycle (Tₘₐₓ : 800°C, soak 1 hour, cycle 8-12 hours). In the latter case, the cycle will be the firing cycle used for the glaze firing. This tends to differ for different types of ware, but typically, may be Tₘₐₓ:1100°C, soak time 1 hour, cycle time 10-14 hours.

Modern computer aided design systems permit an artistic or other image to be scanned into computer memory, or an image to be created solely in computer memory, and permit an image to be modified (for example changed in detail, in size, or merged with another image). Using the present invention with the appropriate printer, a desired image can be printed onto the large sheets of transfer paper that are currently used for the production of screen-printed transfers, but without the preparation of several plates or screens as required for traditional lithographic or screen printing. It can readily be appreciated that the invention offers many advantages in operation, especially since it enables computer image processing to be used for the production of transfers. Printing according to the present invention may provide greatly improved registration of multi-colour prints and other advantages will become clear upon use of the invention.

The invention is illustrated by the following Examples.

### EXAMPLE 1

An adhesive composition was prepared by mixing and stirring:

| | g |
|---|---|
| Sucrose acetate isobutyrate (Special SAIB, from Eastman Kodak) | 65.0 |
| Hamsol 100 (Complex mixture of aromatic petroleum hydrocarbons, from Hammond Chemicals) | 12.0 |
| Ethyl acetate (from BDH) | 31.0 |

This adhesive composition was employed as the ink in a Siemens PT 89 ink-jet printer (which had been modified to override its detection circuit for aqueous ink). Fotocal ceramic transfer paper (from Brittains) was fed to the printer. The composition was printed on the transfer paper in a pattern generated or stored using a Harvard Graphics program operating on an IBM PS/2 model 55SX personal computer and transferred to the printer via its Centronics parallel interface connection. A finely divided ceramic colouring material from the 18/1000 lithographic printing series supplied by Cookson Matthey Ceramics (which contains an anti-caking agent) was applied to the printed transfer paper by hand dusting. The powder stuck to the printed adhesive. Excess powder was removed by cleaning with cotton wool. The transfer was then fed back into the printer and the process repeated using another colour from the 18/1000 series. After completion of the dusting and cleaning, a standard covercoat was applied by K-bar coating and the transfer allowed to dry. The resulting water-slide transfer was of good quality.

The transfer was employed to transfer the pattern on to the surface of a bone china plate in the conventional way, by immersing the transfer in water, sliding the pattern carried by the covercoat on to the plate, and allowing the plate to dry. The plate was then fired to 800°C at a rate of 200° per hour with a 1-hour soak at the peak temperature. The resulting decorated plate was of good quality.

### EXAMPLES 2-4

Adhesive compositions were prepared by mixing and stirring:

### Example 2

| | g |
|---|---|
| Poly(isobutyl methacrylate) solution in butyl acetate and Shellsol A (Crodaplats AC 571 BAN from Croda Resins; Shellsol A is a complex mixture of aromatic petroleum hydrocarbons) | 39.7 |
| Ethyl lactate (from BDH) | 25.3 |

### Example 3

| | g |
|---|---|
| Crodaplast AC 571 BAN (from Croda Resins) | 47.5 |
| Methyl isobutyl ketone (from BDH) | 14.5 |

### Example 4

| | g |
|---|---|
| Sucrose acetate isobutyrate (SAIB from Eastman Kodak) | 25.0 |
| Hamsol 100 (from Hammond Chemicals) | 25.0 |
| Ethyl acetate (from BDH) | 50.0 |

Each of these adhesive compositions was employed in the same way as that of Example 1 to produce a transfer and then use it to decorate a plate except that in the case of the compositions of Examples 3 and 4 only a single colour was employed and in the case of the compositions of Examples 2 and 3 the transfers were not covercoated or used to decorate a plate (since the Examples prove the invention works rather than illustrate industrial production). The transfers and decorated plates were of good quality.

### EXAMPLES 5-7

Adhesive compositions were prepared by mixing and stirring:

### Example 5

| | g |
|---|---|
| Poly(ethyl vinyl acrylate) dispersion in water (3303 from Vinamul) | 20.0 |
| Poly(acrylic acid) homopolymer dispersion in water (PPE 1178 from National Starch) | 20.0 |
| Ethyl lactate (from BDH) | 2.0 |
| Water | 140.0 |
| Poly(propylene glycol) (PPG from Aldrich) | 10.0 |
| Silicone anti-foam (DC 65 from Dow Corning) | 0.01 |

### Example 6

| Part A | g |
|---|---|
| Water | 12.6 |
| 3303 (from Vinamul) | 13.0 |
| Ethyl lactate (from BDH) | 0.46 |

| Part B | g |
|---|---|
| Water | 36.6 |
| Poly(vinyl pyrrolidone) (PVP from Aldrich) | 19.2 |
| DC 65 (from Dow Corning) | 0.01 |

Part A was then mixed and stirred with Part B.

### Example 7

| | g |
|---|---|
| PVP (from Aldrich) | 73.3 |
| Water | 26.7 |
| DC 65 (from Dow Corning) | 0.002 |

Each of these aqueous adhesive compositions was employed in the same way as the adhesive composition of Example 1 except that Fotocal FC ceramic transfer paper (from Brittains) was employed, only a single colour was employed and in the case of the compositions of Examples 5 and 6 the transfers were not covercoated or used to decorate a plate. The transfers and plates were of good quality.

### EXAMPLE 8

A UV (ultra violet)-curable adhesive composition was prepared by mixing and stirring:

| | g |
|---|---|
| Oligo tri-acrylate (OTA 480, of molecular weight 480 from Eastman Kodak) | 25 |
| 2-(Acetoacetoxy)ethyl methacrylate (AAEM from Eastman Kodak) | 72 |
| Hydroxy aryl ketone (Darocure 1173, from BDH) | 3 |

This composition was employed in an analogous way to the adhesive composition of Example 1 to print on to the film-coated gummed paper Fotocal FC (from Brittains). The transfer paper was then hand-dusted with the ceramic colouring material of Example 1. The dusted paper was then passed under a UV lamp which cured the UV-curable composition and hence formed adhesive which stuck the material in the desired pattern to the paper. Excess material was then removed by cleaning with cotton wool.

After completion of the dusting and cleaning, a standard covercoat was applied by screen printing through a stainless steel 80 mesh per inch (32 per cm) screen and the transfer allowed to dry. The resulting water-slide transfer was of good quality.

The transfer was employed to transfer the pattern on to the surface of a bone china plate in the conventional way, by immersing the transfer in water, sliding the pattern carried by the covercoat on to the plate, and allowing the plate to dry. The plate was then fired to 890°C in 90 minutes including a 10 minute soak at the peak temperature. After the soak, the kiln was turned off and allowed to cool. The resulting decorated plate was of good quality.

## Claims

1. A method of producing a decorative or functional transfer carrying a pattern, which method comprises printing the pattern in adhesive or a precursor thereof on transfer paper by an electronically controlled printing process so that the pattern corresponds to an electronically stored or generated digital image, in the case of a precursor converting it to the adhesive, and applying to the adhesive or precursor thereof decorative or functional material in finely divided form, such that the material is stuck by the adhesive and hence forms the pattern in the material.

2. A method according to claim 1 wherein the pattern is printed in adhesive and the decorative or functional material in finely divided form is applied thereto.

3. A method according to claim 2 wherein a tacky layer of the adhesive of from 1 to 30 microns thick is printed.

4. A method according to any one of claims 1-3 wherein the printing is ink-jet printing.

5. A method according to any one of the preceding claims wherein a decorative transfer is produced and the material is decorative colouring material in powder or flake form.

6. A method according to any one of the preceding claims wherein the transfer is decorative and the decorative or functional material is one or more of ceramic colours, precious metal powders and/or flakes and iridescent or micaceous-type pigments.

7. A method according to any one of the preceding claims wherein the transfer is decorative and the decorative or functional material is a ceramic colour comprising colour pigment and a flux in a weight ratio of from 0.1-9 parts of flux to 1 part of pigment.

8. A method according to any one of the preceding claims whose steps are repeated with a different such decorative or functional material to build up a multi-colour or complex effect transfer.

9. A transfer carrying a pattern of decorative or functional material stuck to transfer paper by adhesive, the adhesive or a precursor thereof having been printed in that pattern on the transfer paper by an electronically controlled printing process so that the pattern corresponds to an electronically stored or generated digital image.

10. A transfer according to claim 9 wherein the adhesive has been printed in the pattern.

11. A transfer according to claim 9 or 10 which is decorative and wherein the decorative or functional material is decorative colouring material in powder or flake form.

12. A transfer according to any one claims 9-11 which is decorative and wherein the decorative or functional material is one or more of ceramic colours, precious metal powders and/or flakes and iridescent or micaceous-type pigments.

13. A transfer according to any one of claims 9-12 which is decorative and wherein the decorative or functional material is a ceramic colour comprising colour pigment and a flux in a weight ratio of from 0.1-9 parts of flux to 1 part of pigment.

14. A transfer according to any one of claims 9-13 which has a multi-colour or complex effect built up by having a plurality of such patterns of different decorative or functional materials.

15. A method of forming a decorative or functional pattern on an article, which method comprises transferring the pattern to the article from a transfer claimed in any one of claims 9-14 or produced by a method claimed in any one of claims 1-8.

16. A method according to claim 15 wherein after transferring the pattern, it is fired on the article.

17. A method according to claim 16 wherein the article is ceramic or glass.
